# EUROPÄISCHE PATENTSCHRIFT

(11) **EP 1 684 422 B1**
(45) Veröffentlichungstag und Bekanntmachung des Hinweises auf die Patenterteilung: **13.03.2013**
(21) Anmeldenummer: 06000720.0
(22) Anmeldetag: 13.01.2006
(51) Int. Cl.: H03H 7/25

(54) **Elektronisch schaltbare Eichleitung**
Electronically commutable attenuator
Atténuateur commutable électroniquement

(30) Priorität: 20.01.2005 DE 102005002780
(43) Veröffentlichungstag der Anmeldung: 26.07.2006
(73) Patentinhaber: Rohde & Schwarz GmbH & Co. KG, 81671 München (DE)
(72) Erfinder: Bernhard, Richt, 81827 München (DE)
(74) Vertreter: Körfer, Thomas

(56) Entgegenhaltungen:
- US-A- 4 654 610
- US-A- 6 144 265

## Beschreibung

Die Erfindung betrifft eine Eichleitung gemäβ Hauptanspruch.

Eine Eichleitungen dieser Art ist bekannt (US-P-4,654,610). Bei dieser bekannten Eichleitung werden die zum in Kette schalten der Dämpfungsglieder vorgesehenen PIN-Dioden jeweils durch gesonderte Steuergleichströme geschaltet, je nach Anzahl der eingeschalteten Dämpfungsglieder besitzt eine solche bekannte Eichleitung daher einen relativ hohen Stromverbrauch.

Auch aus US4654610 ist eine Eichleitung dieser Art bekannt. Diese ist mit mehreren Dämpfungsgliedern versehen, die über Längs- und Quer- PIN-Dioden entweder überbrückbar oder in Kette zwischen Eingangstor und Ausgangstor der Eichleitung schaltbar sind, wobei die zum Überbrücken der Dämpfungsglieder dienenden Längs-Dioden in gleicher Richtung gepolt in Reihe zwischen Eingangstor und Ausgangstor geschaltet sind und die zum in Kette schalten dienenden Querdioden jeweils zwischen den Verbindungspunkten dieser Längs-Dioden und den einzelnen Dämpfungsgliedern geschaltet sind, wobei über eine Steuerschaltung am Ausgangstor und an den einzelnen Quer-Dioden eine positive oder negative Steuerspannung jeweils zur Erzeugung eines positiven oder negativen Diodensteuerstromes anschaltbar ist.

Ferner wird durch Anschalten einer Steuerspannung erster Polarität am Ausgangstor und jeweils Steuerspannungen entgegen gesetzter zweiter Polarität an den Quer-Dioden das Eingangstor direkt mit dem Ausgangstor der Eichleitung verbunden wird (0 dB Einstellung) und dass durch Anschalten einer Steuerspannung zweiter Polarität am Ausgangstor sowie jeweils einer Steuerspannung erster Polarität an die zwischen Eingangstor und erstem Dämpfungsglied angeordnete Quer-Diode und an die an der angewählten Stelle der Dämpfungsglieder-Kette angeordnete Quer-Diode die gewünschte Dämpfung eingestellt.

Es ist daher die Aufgabe der Erfindung, eine Eichleitung zu schaffen, die trotz Verwendung von PIN-Dioden als Schalter geringen Steuerstrom benötigt.

Diese Aufgabe wird ausgehend von einer Eichleitung laut Oberbegriff des Hauptanspruches durch dessen kennzeichnende Merkmale gelöst. Vorteilhafte Weiterbildungen ergeben sich aus den Unteransprüchen.

Bei der erfindungsgemäßen Eichleitung ist durch die Anordnung der PIN-Dioden und deren Ansteuerung über Gleichspannungen mit einer gemeinsamen Stromsenke jeweils nur ein einziger Steuerstrom ausreichend, um alle für einen bestimmten Schaltzustand erforderlichen PIN-Dioden gleichzeitig in den ON-Zustand zu schalten. Damit ist der erforderliche Stromverbrauch einer solchen Eichleitung minimal.

Die Erfindung wird im Folgenden anhand einer schematischen Zeichnung an einem Ausführungsbeispiel näher erläutert.

In der Zeichnung zeigen:
- Fig. 1: ein Ausführungsbeispiel der erfindungsgemäßen Eichleitung und
- Fig. 2: ein Diagramm zur Erläuterung der Schaltzustände.

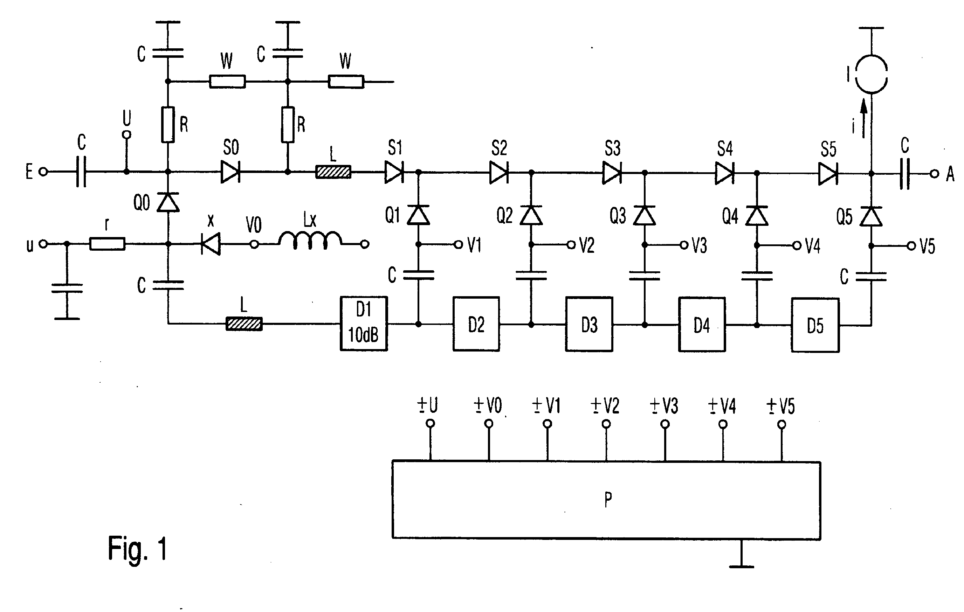

Fig. 1 zeigt das Prinzipschaltbild eines Ausführungsbeispiels einer erfindungsgemäßen RF-Eichleitung, wie sie beispielsweise bei RF-Signalgeneratoren und dergleichen benutzt wird. Am Eingangstor E wird beispielsweise aus einem RF-Verstärker das zu dämpfende RF-Signal eingespeist und steht am Ausgangstor A zur weiteren Verarbeitung zur Verfügung. Die Eichleitung umfasst in dem gezeigten Ausführungsbeispiel 5 Dämpfungsglieder D1 bis D5, beispielsweise von jeweils 10 dB Dämpfung. Diese Dämpfungsglieder können über PIN-Diodenschalter S und Q je nach gewünschter Gesamtdämpfung in gewünschter Anzahl zwischen Eingangstor E und Ausgangstor A in Kette geschaltet oder für 0 dB überbrückt werden.

Die Ansteuerung der PIN-Dioden S und Q erfolgt über Steuergleichspannungen U bzw. V aus einer zentralen Steuerschaltung P. Der durch diese auf Masse bezogenen Steuergleichspannungen erzeugte Steuerstrom i fließt über eine gemeinsame Stromsenke I am Ausgangstor A ab. Die Stromsenke I ist beispielsweise ein Transistor, der so beschaltet ist, dass durch ihn ein konstanter Strom i fließt. Zur Trennung des RF-Signalpfads der Eichleitung und dieses Steuergleichspannungspfades der PIN -Dioden sind zwischen Eingangstor E und Ausgangstor A bzw. vor den Dämpfungsgliedern D1 - D5 und den PIN-Dioden jeweils Koppelkondensatoren C zwischengeschaltet.

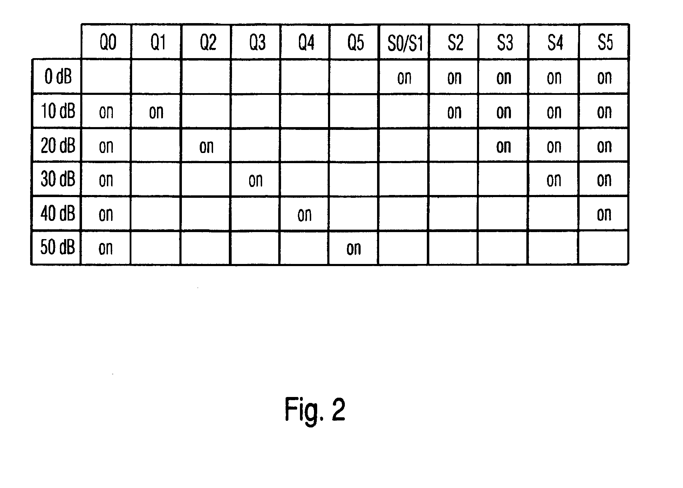

In der Tabelle nach Fig. 2 sind für das gezeigte Ausführungsbeispiel die zur Einstellung der sechs möglichen Dämpfungswerte 0 dB bzw. 10 dB, 20 dB, 30 dB, 40 dB oder 50 dB erforderlichen Schaltzustände der einzelnen PIN-Dioden Q0 bis Q5 bzw. S0 bis S5 dargestellt. Die jeweiligen leeren Felder der Tabelle entsprechen der PIN-Dioden-Schaltstellung OFF. Aus der Tabelle ist ersichtlich, dass für die Dämpfung 0 dB am Steuereingang U eine positive Steuerspannung angelegt und damit ein positiver Steuerstrom eingespeist wird, der an der gemeinsamen Stromsenke I abfließt. Damit werden sämtliche in Reihe geschalteten Längs-Dioden S0 und S1, S2, S3, S4, und S5, durch welche die Dämpfungsglieder D1 - D5 überbrückt werden, in den ON-Zustand geschaltet. Die übrigen Steuereingänge V0 - V5 der Quer-Dioden Q0 - Q5 werden über die Steuerschaltung P mit einer negativen Steuerspannung beaufschlagt und daher in den OFF-Zustand geschaltet, dass heißt gesperrt.

Für eine Dämpfung zwischen 10 dB und 50 dB wird an dem Gleichspannungseingang U über die Steuerschaltung P eine negative Steuerspannung angelegt und an der ersten Quer-Diode Q0 wird über eine positive Steuerspannung V0 ein Steuerstrom eingespeist und so diese erste PIN-Diode Q0 in den ON-Zustand geschaltet. Die Flussrichtung der PIN-Dioden und die Gleichstromzuführung ist gemäß Fig. 1 so gewählt, dass nur ein einziger Steuerstrom i ausreicht, um alle PIN-Dioden des gewünschten RF-Signalpfades für eine bestimmte Dämpfung gleichzeitig in den ON-Zustand zu schalten. Um beispielsweise nur das erste Dämpfungsglied D1 mit 10 dB einzuschalten, wird laut Tabelle neben der ersten Quer-PIN-Diode Q0 auch noch die PIN-Diode Q1 am Ausgang von D1 durch eine positive Steuerspannung V1 in den ON-Zustand geschaltet. Der dadurch erzeugte Steuerstrom fließt durch Q1, S2, S3, S4 und S5 wieder über die gemeinsame Stromsenke I ab.

Damit ist über diese in den ON-Zustand geschalteten Dioden Q0, Q1 bzw. S2 bis S5 nur das erste Dämpfungsglied D1 zwischen Eingangstor E und Ausgangstor A geschaltet. Alle anderen PIN-Dioden (SO, S1 sowie Q2 bis Q5) liegen über die Steuerschaltung P an einer negativen Steuerspannung (-U bzw. -V2 bis -V5) und sind somit im OFF-Zustand.

Zur Einschaltung einer Dämpfung von beispielsweise 40 dB ist laut Tabelle nur die PIN-Diode Q4 durch eine positive Steuerspannung V4 eingeschaltet und durch den dadurch zur Stromsenke I fließende Strom i auch die PIN-Diode S5 im ON-Zustand, die übrigen Quer-PIN-Dioden Q1 bis Q3 und Q5 sind über entsprechende negative Steuerspannungen im OFF-Zustand. Damit sind alle vier ersten Dämpfungsglieder D1, D2, D3 und D4 in Kette zwischen Eingangstor E und Ausgangstor A geschaltet. Die nicht im gewünschten RF-Pfad liegenden Längs-PIN-Dioden (im beschriebenen 40 dB Beispiel die Dioden S0, S1 S2, S3 und S4) werden über die negative Steuerspannung -U im OFF-Zustand gehalten.

Wenn für die technische Realisierung einer solchen Eichleitung eine Technologie verwendet wird, die im Vergleich zur Wellenlänge der maximalen Betriebsfrequenz kleine Abmessungen der Gesamtschaltung zur Folge hat, beispielsweise wenn die Eichleitung in Dünnfilmtechnik, LTCC (Low Temperature Cofired Ceramic) oder MMIC-Technik ausgeführt wird, wird die maximal erzielbare Betriebsdämpfung der Eichleitung durch Übersprechen zwischen Eingangstor und Ausgangstor limitiert. Dieses Übersprechen kann verringert werden, indem der räumliche Abstand zwischen Eingang und Ausgang vergrößert wird. Dies kann erreicht werden, indem zwischen den einzelnen Dämpfungsgliedern und den Schaltern zusätzliche elektrische Leitungsstücke L mit definierter Länge und definiertem Wellenwiderstand zwischengeschaltet werden.

Fig. 1 zeigt zwei solche zwischengeschaltete Leitungsstücke L einmal vor dem Dämpfungsglied D1 und zwischen den in Reihe geschalteten Längs-PIN-Dioden S0 und S1. Entsprechende Leitungsstücke sind vorzugsweise vor jedem einzelnen Dämpfungsglied D und zwischen all den in Reihe geschalteten Längs-PIN-Dioden vorgesehen und nur der Übersichtlichkeit halber in Fig. 1 nicht eingezeichnet. Durch diese Leitungsstücke ist es auch möglich, die gesamte Eichleitung in mehrere einzeln abgeschirmte Module aufzuteilen und so die maximal erreichbare Betriebsdämpfung zu erhöhen.

PIN-Dioden haben einen endlichen ON-Widerstand von beispielsweise 4 Ohm. Dies führt zu einer oft tolerierbaren Dämpfung und Fehlanpassung. Bei der Kettenschaltung mehrerer solcher PIN-Dioden kann dieser ON-Widerstand jedoch nicht vernachlässigt werden. Um die dadurch entstehende Fehlanpassung zu vermeiden kann der ON-Widerstand der PIN-Diode durch zusätzliche Quer-Widerstände R zu einem π-Glied erweitert werden. Der ON-Widerstand der PIN-Diode S0 ist über die Widerstände R, die über Koppelkondensatoren C gegen Masse geschaltet sind, zu einem π-Glied ergänzt. Auch die übrigen in Reihe geschalteten Längs-PIN-Dioden S1 bis S5 sind auf diese Weise zu π-Gliedern ergänzt, was wiederum nur der Übersichtlichkeit halber in Fig. 1 nicht eingezeichnet ist. Auf diese Weise können mehrere Längs-PIN-Dioden in Kette geschaltet werden, ohne die Fehlanpassung zu erhöhen. Prinzipiell können auch die Quer-PIN-Dioden Q der Eichleitung entsprechend kompensiert werden.

Bei der Einstellung der maximalen Dämpfung von 50 dB werden alle 6 PIN-Dioden S im OFF-Zustand (Sperrrichtung) betrieben. Bei identischen Sperrströmen aller PIN-Dioden teilt sich die Sperrspannung auf alle Dioden gleichmäßig auf. In der Praxis sind diese Ströme exemplarabhängig und ungleich und hängen extrem von der Temperatur ab. Um dadurch bedingte undefinierte Zustände auszuschließen, werden die Sperrspannungen zwangsweise auf die Dioden aufgeteilt und zwar wird dazu eine Widerstandskette aus ohmschen Widerständen W vorgesehen, die parallel zu den Längs-PIN-Dioden S geschaltet sind.

Damit die Sperrwirkung der PIN-Dioden im OFF-Zustand durch diese Widerstände W nicht verschlechtert wird (alle Widerstände haben eine schädliche Parallelkapazität), werden diese Widerstände W nicht direkt parallel zu den PIN-Dioden angeordnet sondern, wie in Fig. 1 bezüglich der ersten PIN-Diode S0 dargestellt ist, zwischen den Widerständen R des π-Gliedes, die über die Koppelkondensatoren C nach Masse geschaltet sind. Dadurch liegt die Parallelkapazität dieser Widerstände W für die RF zwischen Knoten mit Massepotential und ist damit nicht schädlich.

In dem Ausführungsbeispiel nach Fig. 1 ist wiederum nur für die erste PIN-Diode dieser Widerstand W dargestellt. Die anderen parallel zu den übrigen Längs-PIN-Dioden angeordneten Widerstände W sind der Übersichtlichkeit halber in Fig. 1 wieder weggelassen. Die Aufteilung der Sperrspannung auf die einzelnen PIN-Dioden kann durch unterschiedliche Werte dieser Widerstände W beliebig gewählt werden. Die Widerstände W sind so dimensioniert, dass der Strom durch sie ein Mehrfaches des maximal zu erwartenden Sperrstromes der PIN-Dioden beträgt.

Die Verbindung bei eventuell räumlich getrennten Widerständen W kann durch entsprechende Leitungsstücke mit prinzipiell beliebigem Wellenwiderstand erfolgen. Bei niederohmiger Auslegung dieser Leitungsstücke können insbesondere für hohe Frequenzen diese Leitungsstücke gleichzeitig die Funktion der Koppelkondensatoren gegen Masse übernehmen. Es können auch Kettenschaltungen von Leitungsabschnitten unterschiedlicher beliebiger Wellenwiderstände und konzentrierter Elemente wie Durchführungsfilter, Widerstände, Spulen etc. eingesetzt werden, um beispielsweise das RF-Übersprechen zwischen einzelnen Modulen einer solchen Eichleitung durch solche Leitungsstücke zu verringern.

Zur Entkopplung des RF-Signalpfades von den Steuerspannungsquellen sind in den Steuerleitungen Drosselspulen angeordnet, wie dies für die 1. PIN-Diode durch die Spule Lx angedeutet ist. Die Realisierung von Induktivitäten, die von einer niedrigen RF-Frequenz von beispielsweise 9 kHz bis zu sehr hohen Frequenzen von beispielsweise 6 GHz rein induktives Verhalten haben, ist jedoch nicht möglich. Jede reale Spule hat ohmsche Verluste und vor allem eine Parallelkapazität, die mit steigender Induktivität zunimmt. Diese Parallelkapazität ist bei hohen RF-Frequenzen dominierend und sehr störend. Bei der Gleichspannungszufuhr der Steuerspannungen V0 bis V5 zu den Quer-PIN-Dioden Q0 bis Q5 kann diese Parallelkapazität der Spule Lx für den Fall einer negativen Sperrspannung dadurch verhindert werden, dass zusätzliche PIN-Dioden in den Gleichspannungs-Zuführungspfad eingefügt werden, wie dies für die PIN-Diode Q0 in Fig. 1 mit der PIN-Diode x dargestellt ist, die in Reihe zur Spule Lx angeordnet ist.

Entsprechende Spulen Lx und zusätzliche PIN-Dioden x sind natürlich auch in die Steuerpfade der anderen Quer-PIN-Dioden Q1 bis Q5 eingefügt und nur der Übersichtlichkeit halber wieder nicht eingezeichnet. Damit die Sperrspannungen an diesen zusätzlichen PIN-Dioden x definierte Werte haben, wird über zusätzliche Widerstände r jeweils eine Gleichspannung u zugeführt. Die Größe dieser Spannung bestimmt die Aufteilung der Sperrspannung auf die PIN-Dioden Q und x. Diese Widerstände r können wie die Widerstände R der π-Glieder dimensioniert werden und in Serie mit Koppelkondensatoren nach Masse geschaltet sein, um so auch die ON-Widerstände der Quer-PIN-Dioden Q zu π-Gliedern zu ergänzen und so Fehlanpassungen zu vermeiden.

Anstelle der beiden in Reihe geschalteten Dioden S0 und S1 am Eingang könnte auch nur eine einzige Diode vorgesehen sein. Die Anordnung von 2 Dioden in Reihe ermöglicht jedoch die Aufteilung der gesamten Eichleitung in einzelne Module. Die beschriebenen Polaritäten der Steuerspannungen der PIN-Dioden könnten auch invertiert werden, wenn gleichzeitig die Richtung des Steuerstroms i der Stromsenke invertiert wird.

Die Erfindung ist nicht auf die beschriebenen Ausführungsbeispiele beschränkt, sondern allein durch den Umfang der Ansprüche beschränkt.

## Patentansprüche

1. Eichleitung mit mehreren Dämpfungsgliedern (D1 - D5), die über Längs- und Quer- PIN-Dioden (S u. Q) entweder überbrückbar oder in Kette zwischen Eingangstor (E) und Ausgangstor (A) der Eichleitung schaltbar sind, wobei die zum Überbrücken der Dämpfungsglieder (D1 - D5) dienenden Längs-Dioden (SO -S5) in gleicher Richtung gepolt in Reihe zwischen Eingangstor (E) und Ausgangstor (A) geschaltet sind und die zum in Kette schalten dienenden Querdioden (Q0 - Q5) jeweils zwischen den Verbindungspunkten dieser Längs-Dioden (SO -S5) und den einzelnen Dämpfungsgliedern (D1 - D5) geschaltet sind,
wobei über eine Steuerschaltung (P) am Eingangstor (E) und an den einzelnen Quer-Dioden (Q0 - Q5) eine positive oder negative Steuerspannung (U bzw. V) jeweils zur Erzeugung eines positiven oder negativen Diodensteuerstromes zu einer gemeinsamen Stromsenke (I) am Ausgangstor (A) angeschaltet ist,
wobei durch Anschalten einer Steuerspannung erster Polarität (+U) am Eingangstor (E) und jeweils Steuerspannungen entgegen gesetzter zweiter Polarität (-V0 bis -V5) an den Quer-Dioden (Q0 - Q5) das Eingangstor (E) direkt mit dem Ausgangstor (A) der Eichleitung verbunden wird (0 dB Einstellung) und dass durch Anschalten einer Steuerspannung zweiter Polarität (-U) am Eingangstor (E) sowie jeweils einer Steuerspannung erster Polarität (+V0 und z. B. +V2) an die zwischen Eingangstor (E) und erstem Dämpfungsglied (D1) angeordnete Quer-Diode (Q0) und an die an der angewählten Stelle der Dämpfungsglieder-Kette angeordnete Quer-Diode (z. B. Q2) die gewünschte Dämpfung (z. B. 20 dB) eingestellt wird, und
wobei am gemeinsamen Stromausgang am Ausgangstor (A) eine Stromsenke (I) angeordnet ist, wobei die Stromsenke ein Transistor ist, der so beschaltet ist, dass durch ihn ein konstanter Strom (i) fließt.

2. Eichleitung nach Anspruch 1,
**dadurch gekennzeichnet,**
**dass** zur Trennung von RF-Signalpfad und Steuergleichspannungs-Signalpfad am Eingangs- und Ausgangstor (E, A) sowie zwischen den Quer-Dioden (Q) und den Dämpfungsgliedern (D) jeweils Trennkondensatoren(C) angeordnet sind.

3. Eichleitung nach Anspruch 1 oder 2,
**dadurch gekennzeichnet,**
**dass** zwischen den in Reihe geschalteten Längs-Dioden (S) sowie den zu den Dämpfungsgliedern (D) führenden Quer-Dioden (Q) jeweils Leitungsstücke (L) definierten Wellenwiderstandes geschaltet sind.

4. Eichleitung nach einem der vorhergehenden Ansprüche,
**dadurch gekennzeichnet,**
**dass** die Längs-Dioden (S) jeweils mit ohmschen Quer-Widerständen (R) zu π-Gliedern zusammengeschaltet sind.

5. Eichleitung nach Anspruch 4,
**dadurch gekennzeichnet,**
**dass** die ohmschen Quer-Widerstände (R) jeweils über Trennkondensatoren (C) an Masse geschaltet sind.

6. Eichleitung nach einem der vorhergehenden Ansprüche,
**dadurch gekennzeichnet,**
**dass** parallel zu den Längs-Dioden (S) zusätzliche in Reihe geschaltete ohmsche Parallelwiderstände (W) angeordnet sind.

7. Eichleitung nach Anspruch 4 und 6,
**dadurch gekennzeichnet,**
**dass** Parallelwiderstände (W) zwischen den ohmschen Quer-Widerständen (R) der π-Glieder angeordnet sind.

8. Eichleitung nach Anspruch 6 oder 7,
**dadurch gekennzeichnet,**
**dass** zwischen den in Reihe geschalteten Parallelwiderständen (W) jeweils Leitungsstücke angeordnet sind.

9. Eichleitung nach einem der vorhergehenden Ansprüche,
**dadurch gekennzeichnet,**
**dass** in die zu den Quer-Dioden (Q) führenden Steuerleitungen jeweils zusätzliche PIN-Dioden (x) eingefügt sind.

10. Eichleitung nach Anspruch 9,
**dadurch gekennzeichnet,**
**dass** die zusätzlichen PIN-Dioden (x) über zusätzliche Widerstände (r) jeweils mit einer Gleichspannung (u) vorgespannt sind.

## Claims

1. Calibration line having a plurality of attenuators (D1-D5) which, via longitudinal and transverse PIN diodes (S u. Q), are either bridgeable or can be connected in a chain between input port (E) and output port (A) of the calibration line, in which the longitudinal diodes (S0-S5) used to bridge the attenuators (D1-D5) are connected, polarized in the same direction, in series between input port (E) and output port (A), and the transverse diodes (Q0-Q5) used for connecting in a chain are respectively connected between the tie points of said longitudinal diodes (S0-S5) and the individual attenuators (D1-D5),
in which a positive or negative control voltage (U or V, respectively) is connected via a control circuit (P) at the input port (E) and at the individual transverse diodes (Q0-Q5) for the respective purpose of generating a positive or negative diode control current to a common current sink (I) at the output port (A),
in which the input port (E) is connected directly to the output port (A) of the calibration line (0 dB setting) by connecting a control voltage of first polarity (+U) at the input port (E) and, respectively, control voltages of opposite, second polarity (-V0 to -V5) at the transverse diodes (Q0-Q5), and the desired attenuation (for example 20 dB) is set by connecting a control voltage of second polarity (-U) at the input port (E) as well as respectively a control voltage of first polarity (+V0 and for example +V2) to the transverse diode (Q0) arranged between input port (E) and first attenuator (D1), and to the transverse diode (for example Q2) arranged at the selected location of the attenuator chain, and
in which a current sink (I) is arranged at the common current output at the output port (A), the current sink being a transistor which is connected so that a constant current (i) flows through it.

2. Calibration line according to Claim 1, **characterized in that** in order to separate RF signal path and DC control voltage signal path separating capacitors (C) are respectively arranged at the input and output ports (E, A) and between the transverse diodes (Q) and the attenuators (D).

3. Calibration line according to Claim 1 or 2, **characterized in that** line pieces (L) of defined surge impedance are respectively connected between the series-connected longitudinal diodes (S) and the transverse diodes (Q) leading to the attenuators (D).

4. Calibration line according to one of the preceding claims, **characterized in that** the longitudinal diodes (S) are respectively interconnected to ohmic transverse resistors (R) to form π-elements.

5. Calibration line according to Claim 4, **characterized in that** the ohmic transverse resistors (R) are respectively connected to earth via separating capacitors (C).

6. Calibration line according to one of the preceding claims, **characterized in that** additional series-connected ohmic parallel resistors (W) are arranged in parallel with the longitudinal diodes (S).

7. Calibration line according to Claims 4 and 6, **characterized in that** parallel resistors (W) are arranged between the ohmic transverse resistors (R) of the π-elements.

8. Calibration line according to Claim 6 or 7, **characterized in that** line pieces are respectively arranged between the series-connected parallel resistors (W).

9. Calibration line according to one of the preceding claims, **characterized in that** additional PIN diodes (x) are respectively inserted into the control lines leading to the transverse diodes (Q).

10. Calibration line according to Claim 9, **characterized in that** the additional PIN diodes (x) are respectively biased with a DC voltage (u) via additional resistors (r).

## Revendications

1. Atténuateur comportant plusieurs éléments d'amortissement (D1-D5), qui soit peuvent être pontés soit être commutés en série entre une porte d'entrée (E) et une porte de sortie (A) de l'atténuateur par l'intermédiaire de diodes PIN longitudinales et transversales (S et Q), dans lequel les diodes longitudinales (S0-S5) servant à ponter les éléments d'amortissement (D1-D5) sont montées polarisées dans la même direction, en série entre la porte d'entrée (E) et la porte de sortie (A), et les diodes transversales (Q0-Q5) servant au montage en série sont montées respectivement entre les points de liaison de ces diodes longitudinales (S0-S5) et les différents éléments d'amortissement (D1-D5),
dans lequel une tension de commande positive ou négative (U ou V) est reliée par l'intermédiaire d'un circuit de commande (P) à la porte d'entrée (E) et aux différentes diodes transversales (Q0-Q5) respectivement pour générer un courant de commande de diode positif ou négatif vers un récepteur de courant commun (I) à la porte de sortie (A),
dans lequel la porte d'entrée (E) est directement reliée (réglage 0 dB) à la porte de sortie (A) de l'atténuateur grâce à l'application d'une tension de commande d'une première polarité (+U) à la porte d'entrée (E) et respectivement de tensions de commande d'une seconde polarité opposée (-V0 à -V5) aux diodes transversales (Q0-Q5), et en ce que l'amortissement souhaité (par exemple 20 dB) est réglé grâce à l'application d'une tension de commande de seconde polarité (-U) à la porte d'entrée (E) ainsi que respectivement d'une tension de commande de première polarité (+V0 et par exemple +V2) à la diode transversale (Q0) disposée entre la porte d'entrée (E) et un premier élément d'amortissement (D1) et à la diode transversale (par exemple Q2) disposée à l'endroit sélectionné de la série d'éléments d'amortissement, et
dans lequel un récepteur de courant (I) est disposé à la sortie de courant commune à la porte de sortie (A), dans lequel le récepteur de courant est un transistor, qui est monté de telle sorte qu'un courant constant (i) passe à travers lui.

2. Atténuateur selon la revendication 1, **caractérisé en ce que**
des condensateurs de séparation (C) sont respectivement disposés en vue de la séparation d'un trajet de signal RF et d'un trajet de signal de tension continue de commande à la porte d'entrée et à la porte de sortie (E, A) ainsi qu'entre les diodes transversales (Q) et les éléments d'amortissement (D).

3. Atténuateur selon la revendication 1 ou 2, **caractérisé en ce que**
des segments de ligne (L) d'impédance définie sont montés respectivement entre les diodes longitudinales (S) disposées en série ainsi que les diodes transversales (Q) conduisant aux éléments d'amortissement (D).

4. Atténuateur selon l'une des revendications précédentes, **caractérisé en ce que**
les diodes longitudinales (S) sont interconnectées respectivement avec des résistances transversales ohmiques(R) aux éléments π.

5. Atténuateur selon la revendication 4, **caractérisé en ce que**
les résistances transversales ohmiques (R) sont reliées respectivement à la masse par l'intermédiaire des condensateurs de séparation (C).

6. Atténuateur selon l'une des revendications précédentes, **caractérisé en ce que**
parallèlement aux diodes longitudinales (S) sont disposées des résistances parallèles ohmiques (W) supplémentaires montées en série.

7. Atténuateur selon les revendications 4 et 6, **caractérisé en ce que**
des résistances parallèles (W) sont disposées entre les résistances transversales ohmiques (R) des éléments π.

8. Atténuateur selon la revendication 6 ou 7, **caractérisé en ce que**
des segments de ligne respectifs sont disposés entre les résistances parallèles (W) montées en série.

9. Atténuateur selon l'une des revendications précédentes, **caractérisé en ce que**
des diodes PIN supplémentaires respectives (x) sont ajoutées dans les lignes de commande conduisant aux diodes transversales (Q).

10. Atténuateur selon la revendication 9, **caractérisé en ce que**
les diodes PIN supplémentaires (x) sont polarisées respectivement par une tension continue (u) grâce aux résistances supplémentaires (r).
